# EUROPEAN PATENT SPECIFICATION

(11) **EP 1 451 825 B1**
(45) Date of publication and mention of the grant of the patent: **14.03.2007**
(21) Application number: 02804659.7
(22) Date of filing: 18.11.2002
(51) Int. Cl.: G11C 11/00, H01L 21/8239

(54) **A MATRIX-ADDRESSABLE ARRAY OF INTEGRATED TRANSISTOR/MEMORY STRUCTURES**
MATRIXADRESSIERBARES ARRAY INTEGRIERTER TRANSISTOR-/SPEICHERSTRUKTUREN
RESEAU A ADRESSAGE MATRICIEL DE STRUCTURES DE TRANSISTOR/MEMOIRE INTEGREES

(30) Priority: 10.12.2001 NO 20016041
(43) Date of publication of application: 01.09.2004
(73) Proprietor: Thin Film Electronics ASA, 0124 Oslo (NO)
(72) Inventor: GUDESEN, Hans, Gude, B-1000 Brussels (BE)
(74) Representative: Johnson, Terence Leslie
(86) International application number: PCT/NO2002/000426
(87) International publication number: WO 2003/050814

(56) References cited:
- EP-A1- 0 902 465
- EP-A2- 1 187 123
- US-A- 4 952 031
- US-A- 6 072 716
- PATENT ABSTRACTS OF JAPAN vol. 1999, no. 7 31 March 1999 & JP 07 106 450 A (OLYMPUS CO LTD; SYMMETRICS CORP) 21 April 1995

## Description

The present invention concerns a matrix-addressable array of integrated transistor/memory structures, as described in the preamble of claim 1. Such a matrix-addressable array is known from JP07106450.

A major problem in modem computing is the physical split between storage devices and processing units, more specifically between CPUs and operating software, user software and user data. Recent improvements in effective CPU speeds (e.g. the development from Pentium II onwards) has been enabled by integrating increasingly more memory capacity inside the CPU (SRAM/EEPROM), however, the overall speed is still seriously hampered by the fact that most software and data still uses the hard disk as primary storage medium. Although the transfer rate of hard disks has improved in recent years, as have the capacity of buses, the maximum speed potential is still controlled by the very slow access speed of the hard disks, a speed which barely has improved the last 10-15 years, and which will not improve substantially either as long as this primary storage medium remains a mechanically operated device.

If the bulk of data now using the hard disk could utilize memory capacity inside the CPU itself, not just would the speed gains become extreme, even more important could be the fact that entirely novel types of processing and computing devices could be envisaged, opening up for new approaches to (parallized) software, much more adapted to solving complex problems (e.g. non-indexed searches, continuous speech recognition, artificial intelligence, etc.).

The increasing incompatibility between storage devices and processing units deriving from the physical split therebetween not only leads to severe capacity problems, but is also causing latency and inefficient exploitation of high-speed processing circuitry.

Hence, a major object of the present invention is to obviate or eliminate the above problems by introducing a novel architecture allowing the integration of non-volatile memory and high-speed transistor circuitry which can be applied to inorganic as well as organic electronics or hybrids thereof, and which moreover is not limited to planar devices, but equally well applicable to volumetric devices.

The above object as well as further advantages and features are realized with the matrix-addressable array according to claim 1.

In an advantageous embodiment of the matrix-addressable array according to the present invention the transistor/memory structure comprises a third electrode layer of semiconducting material opposite the source and drain electrode layer, said third electrode layer comprising a second gate electrode extending in the same direction as the first gate electrode and registering therewith, whereby the transistor/memory structure is realized as a dual gate field-effect transistor.

According to the invention the first memory cell contacts the source and the gate electrodes, the second memory cell contacts the drain and the gate electrodes, and the third memory cell contacts the source and the drain electrodes. In the latter case the memory material in the third memory cell preferable has a thickness different from that of the first and second memory cells, and in that case the memory material preferably is a ferroelectric or electret organic material, preferably a polymer or copolymer.

In the matrix-addressable array according to the invention the semiconducting material advantageously is an inorganic semiconducting material, preferably amorphous silicon, polycrystalline silicon or microcrystalline silicon; or the semiconducting material is advantageously an organic semiconducting material, preferably a semiconducting polymer or pentacene.

In a second advantageous embodiment of the matrix-addressable array according to the invention an additional transistor memory is provided in registration with the first single transistor/memory structure opposite the gate electrode thereof and inverted in relation to the first single transistor memory structure, said additional transistor/memory structure sharing the same gate electrode with the latter, thus realizing a dual transistor/memory structure with common gate and six memory cells, and then the dual transistor/memory structure preferably realizes a common gate complementary field-effect transistor. In a variant of this second embodiment the dual transistor memory structure advantageously is provided with at least one additional gate electrode, said at least one additional gate electrode being provided on one of the layers of seiniconducting material opposite the source/drain electrode layer.

In a third advantageous embodiment of the matrix-addressable area according to the invention, the matrix-addressable array is realized as a three-dimensional array by stacking two or more two-dimensional arrays of transistor/memory structures, and that a two-dimensional array is isolated from an adjacent neighbouring two-dimensional array by a separation layer, and then the separation layer preferably is selected as one of the following, viz. a layer of insulating material, a layer of conducting or semiconducting material coated to form an insulating barrier, or a layer of conducting or semiconducting material surface-oxidized to form the insulating barrier.

The invention shall now be explained in more detail with reference to its prerequisite technological background as well as a discussion of preferred embodiments thereof and with reference to the accompanying drawing figures, in which
fig. 1a shows a cross section of a prior art array of field-effect transistor structures wherein the electrodes are provided in dense arrangement,
fig. 1b a plan view of the array in fig. 1a,
fig. 2a a cross section of a single integrated transistor/memory structure as provided in the present invention,
fig. 2b a plan view of the transistor/memory structure in fig. 2a,
fig. 2c a perspective view of the geometrical layout of memory material in the transistor/memory structure in fig. 2a,
fig. 3a a first preferred embodiment of a dual transistor/memory structure according to the invention,
fig. 3b a variant of the embodiment of fig. 3a,
fig. 3c a second embodiment of a dual transistor/memory structure according to the invention,
fig. 3d a third embodiment of a dual transistor memory structure according to the invention, and
fig. 4 a three-dimensional matrix-addressable array according to the invention.

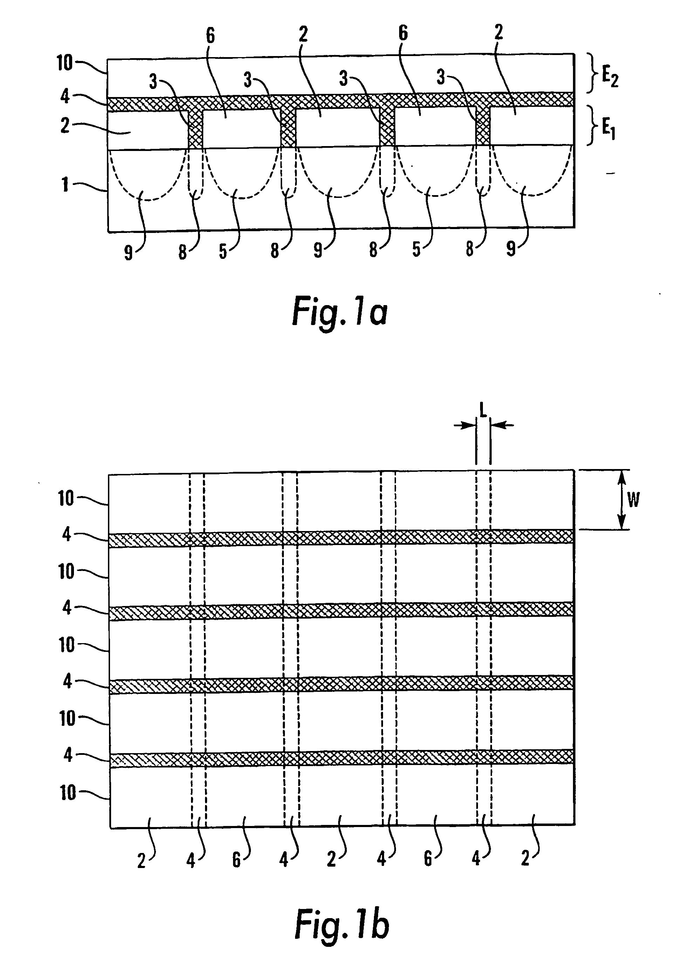

The general background of the present invention shall now be briefly discussed. At its very foundation lays the concept of a dense electrode arrangement which has been disclosed in the published international patent application WO 03/041084, falling under Art 54 (3) EPC and belonging to the same applicant. A dense electrode arrangement as described therein corresponds to the electrode arrangements shown in cross section in fig. 1a and plan view in fig. 1b, in casu the arrangement of the electrodes in the electrode layers E₁ and E₂ as indicated in fig. 1a. Instead of being restricted by a pitch deriving from constraints imposed by design rules of conventional patterning technology, e.g. photomicrolithography, separate patterning and molding processes are used to form electrode sets E₁; E₂ with e.g. in each case parallel strip-like electrodes separated by an arbitrarily small distance and mutually electrically insulated by an insulating material 4 provided in recesses 3 between e.g. electrodes 2,6 of the electrode set E₁. Crosswise oriented electrodes 10 of the electrode layer E₂ can be similarly laid out and mutually insulated in a corresponding manner by an insulating material or barrier 4 as seen to advantage in the plan view in fig. 1b. Since the separation between the electrodes 2;6 indicated by the distance L in fig. 1b is not subject to any design rules, and in principle can be of equal magnitude to the thickness of a layer 4 deposited by methods which in theory would allow a magnitude of L down to monoatomic size, the dense electrode arrangement as disclosed in the above-mentioned international patent application allows the realization of dense matrices of cells of functional material provided say between electrode sets such as E₁ and E₂ and addressable thereby.

Moreover, the present invention also has its basis in the published international patent application, WO 03/046921 falling under Art 54(3) EPC and belonging to the same applicant and which describes transistor matrices consisting of field-effect transistor structures with ultrashort channel length L and arbitrarily large channel width W, thus offering possibilities in field-effect transistor designs hitherto undreamt of. Hence fig. 1a can be taken to render a cross section of transistor structures arranged in a matrix, as readily can be seen from the plan view in fig. 1b. In fig. 1a a source electrode 2 is formed in the first electrode layer E₁ running parallel to drain electrode 6 of about similar dimensions. Source and drain electrodes 2;6 are provided on a semiconducting substrate 1 e.g. of silicon which by means of method and processes described in the above-mentioned international patent application has been doped to form source regions 9 and drain regions 5 in the silicon substrate, which additionally has been doped beneath the recesses 3 formed between the source and drain electrodes 2;6 to form a transistor channel 8 of ultrashort length L. The source and drain electrodes are as before isolated by barrier material 4 filling the recesses 3 therebetween and covering the top surfaces thereof, thus providing an insulating layer 4. The crosswise oriented gate electrodes 10 of the field-effect transistor structures are provided as seen to advantage in the plan view in fig. 1b. The channel length L of the transistor channel 8 can be made almost arbitrarily small, conforming to the thickness of a layer 4 which by methods well-known to persons skilled in the art can be deposited with thickness down to almost monoatomic size. On the other hand the channel width W will be given by the width of the gate electrodes 10 and hence the ratio W/L can be made very large, thus giving a very high drain current I_{D} as desirable. Present-day technology for patterning in the region well beyond the 0,1 µm range will hence allow transistor matrices as shown in e.g. fig. 1b and with transistor structures realized in a corresponding small scale.

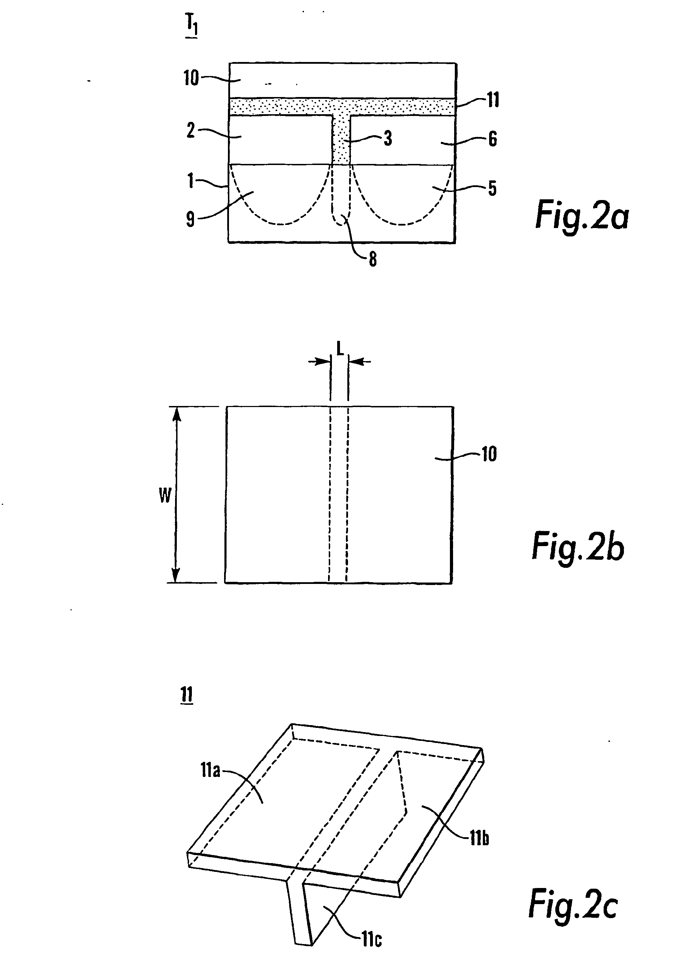

The basic technology as disclosed in the two above-mentioned international patent applications now forms point of departure for realizing a matrix-addressable array of integrated transistor/memory structures according to the present invention. A single transistor/memory structure T₁ according to the present invention is shown in fig. 2a and appears structurally similar to corresponding structures in e.g. fig. 1a. As before, a source electrode 2 and a drain electrode 6 are provided on a substrate or layer 1 of semiconducting material which has suitably been doped to form a source region 9, an ultrashort transistor channel 8 and a drain region 5 in the semiconducting substrate. Now, instead of providing a barrier of insulating material 4 as shown in fig. 1a, this material is replaced by a memory material in the form of a thin layer 11 of a polarizable dielectric material capable of exhibiting hysteresis, particularly a ferroelectric or electret material. Preferably can then the ferroelectric memory material as known to persons skilled in the art be a ferroelectric polymer or copolymer and then in the latter case most preferably a polyvinylidene fluoride/tri-fluoroethylene copolymer (PVDF-TrFE) which can be deposited in extremely thin layers, e.g. down to a nanometer scale, and which of course, being a ferroelectric material, also can provide the necessary insulating properties. The memory material 11 is provided as shown in fig. 2a, filling the recess 3 between the source and drain electrodes 2;6 and covering the top surfaces thereof, providing insulation or a barrier against the gate electrode 10. The transistor/memory structure T₁ is thus now also combined with the memory material 11 to form three separate memory cells which better can be seen in fig. 2c, which in perspective shows a layer of memory material 11 with all other features removed. This memory material 11 now has three distinct portions, viz. first portion 11a forming a first memory cell which can be addressed via the gate electrode 10 and the source electrode 2, a second portion 11b forming a second memory which can be addressed via the gate electrode 10 and the drain electrode 6, and a third portion 11c forming a third memory cell in the recess 3 between the source and drain electrodes 2;6 and addressable thereby. These three memory cells 11a, 11b, 11c can be addressed, i.e. read and written independently of the operation of the field-effect transistor proper. In this connection it should be understood that three memory cells can store a three bit word, i.e. for instance any of the binary words 000, 001, 010, 011, 100, 101 and 111. Write/read of such three bit binary words will of course be a matter of protocol, as well-known to persons skilled in the art, and shall not be further discussed herein. The whole operation of the device shall be explained more fully in the following section.

The memory material 11 forming the three memory cells 11a, 11b, 11c as shown in fig. 2c allows multidirectional switching as shall now be explained. The first cell 11a corresponds to the portion of memory material 11 between the source electrode 2 and the gate electrode 10 and will be switched in a direction orthogonal to the surfaces of these electrodes and the memory cell by applying a voltage to the source electrode 2 and the gate electrode 10, creating a potential therebetween and an electric field across the memory cell 11 a, which now as an e.g. ferroelectric memory material can be polarized in either the up and down direction and thus allowing the storage of a binary digit. The same consideration applies to the memory cell 11b in the portion of the memory material 11 between the drain electrode 6 and the gate electrode 10. In addition a third memory cell 11c is provided by the memory material 11 in the recess 3 between the source electrode 2 and the drain electrode 6 and will be similarly switched by applying voltage between these, setting up an electric field across the memory cell 11c therebetween. In a typical preferred ferroelectric material such as polyvinylidene trifluoride-trifluoroethylene (PVDF-TrFE), a certain field strength will be necessary in order to polarize the material and switch between the two polarization states representing either a binary 0 or binary 1. The field strength required is in other words related to the thickness of the thin-film memory material 11, and the thickness thereof in the memory cells 11a and 11b can be different from that in the memory cell 11c. For practical purposes the memory cell 11a can now be denoted source/gate memory cell (S/G memory cell) and similarly memory cell 11b the drain/gate memory cell (D/G memory cell), while then of course memory cell 11c can be denoted the source/drain memory cell (S/D memory cell). As the S/G and D/G memory cell material 11 have the same thickness, these two cells will be switched by the same applied field strength, while the memory material in the S/D memory cell can be thicker or thinner than in the two former memory cells, and hence shall allow switching at a different field strength between the source and drain electrodes 2;6. Now the transistor structure formed by the source and drain electrodes 2;6 the doped regions 5,8,9 and the gate electrodes 10 shall allow the transistor switching independently of the memory switching and this implies that the transistor shall be switched by allowing a lower source or drain voltage than that required to switch the S/D memory cell and a gate electrode voltage much lower than that required for switching either the S/G memory cell or the D/G memory cell. In practice, the switching of these latter two memory cells will be completely independent of the transistor switching.

Now various preferred structural embodiments of the transistor/memory structures according to the invention shall be discussed.

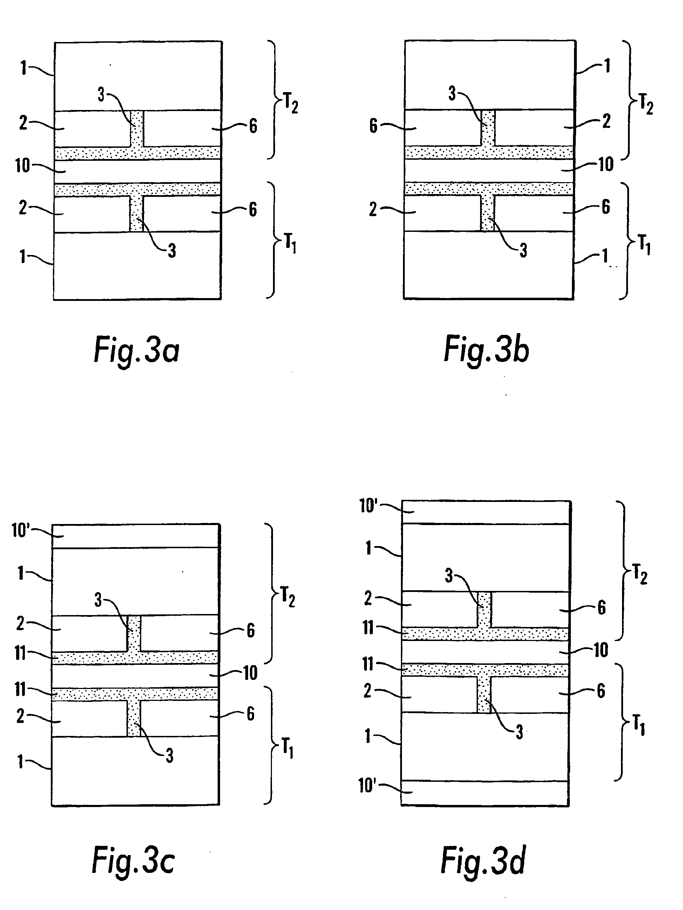

Fig. 3a shows a first preferred embodiment wherein a second transistor/memory structure is provided above a first single transistor/memory structure T₁. The two transistor/memory structures T₁, T₂ shares the same gate electrode 10, while the electrode layers comprising the source/drain electrodes 2;6 are provided inverted respective to each other on opposite sides of the common gate electrode 10. The doped regions of the transistors are as before found in the semiconducting substrate 1 provided on either side in each of the transistor/memory structures T₁;T₂ as shown. These combined structures actually are a common gate transistor structure and could appropriately connected be used to realize a common gate complementary transistor circuit where T₁ forms the first transistor of the circuit and T₂ the second transistor of the circuit. It is, of course, then to be understood that the substrates 1 must be doped accordingly to form respectively a npn or a pnp channel structure. A similar dual transistor/memory structure is shown in fig. 3b, but now with the positions of the source and drain electrodes 2;6 reversed in their respective transistor/memory structures T₁;T₂. As will be seen the dual transistor/memory structures in fig. 3a and 3b are realized with six memory cells that can be separately addressed. It will also be evident that the structures depicted in figs. 3a and 3b shall allow six independently switchable memory cells and thus the possibility of storing a six bit binary word and writing and reading the same with any suitable protocol as obvious to persons skilled in the art.

A second embodiment of the dual transistor/memory structure is shown in fig. 3c, wherein the second transistor/memory structure T₂ is provided with a second gate electrode 10, thus making T₂ a dual gate transistor/memory structure.

A third embodiment of dual transistor/memory structure is shown in fig. 3d and is similar to the embodiment in fig. 3c, but now also with a second gate electrode 10' added to the transistor/memory structure T₁, thus making both structures T₁;T₂ dual gate transistor/memory structures with gate electrodes 10, 10'.

The substrate, i.e. the layer of semiconducting material 1 can preferably be made of silicon; in case either amorphous, polycrystalline or microcrystalline silicon. Another advantage of an inorganic semiconductor material such as silicon is of course the possibility of forming barrier layer thereupon by performing a surface oxidation thereof. But there is nothing to prevent the layer of semiconductor material being an organic semiconductor, e.g. a semiconducting polymer or a cyclic compound such as pentacene, as well-known to persons skilled in the art. Laying down the electrodes of the electrode layer E₁ on an organic semiconducting material, one must then, take precautions to heed the compatibility between the electrodes materials and any organic semiconducting material with regard to process temperature regime and so on.

The memory material 11 shall be a dielectric and polarizable material with ferroelectric or electret properties that is capable of showing hysteresis when subjected to an electrical field. Most preferably such materials will be organic as mentioned, polymers or copolymers and even more preferably FVDF-TrFE will be used as memory material. An added advantage of such memory materials is that their dielectric properties allow their function as electrically insulating barrier materials as well, and further advantage is the possibility of applying them in global layers of extreme thinness down to few nanometres and finally that they can easily be applied on complex surface geometries to form memory cells, including complete filling of the recesses 3 such as formed between the source and drain electrodes 2;6.

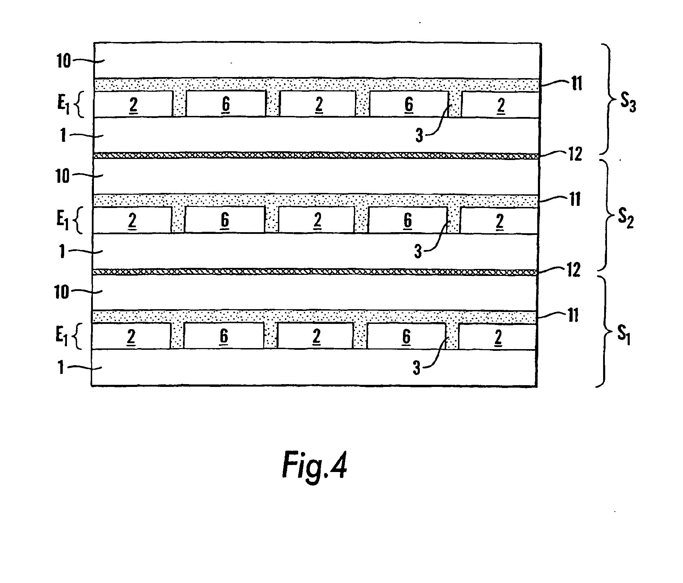

In the preceding sections the matrix-addressable array of transistor/memory structures have been more or less treated as a kind of two-dimensional array, but it is also possible to stack such two-dimensional arrays to form three-dimensional arrays, as shown in fig. 4, which renders a three-dimensional matrix-addressable array according to the invention and formed by three stacked two-dimensional arrays S₁, S₂, S₃. The point of departure here is of course, the single transistor/memory structure in fig. 1a, but a three-dimensional matrix-addressable arrays of such transistor memory structures need not be limited to that particular one, but could rely on the dual structures for instance shown in fig. 3a-3d, and other combinations of electrode layers and layers of semiconducting material will be possible with the only constraint that separate switching of respectively the transistor structure proper and the memory cells must also be possible. As will be seen, is the three-dimensional matrix-addressable array shown in fig. 4 with three stacks S₁ of two-dimensional arrays formed with a single layer 1 of semiconducting material, a first electrode layer E₁ comprising the source and drain electrodes 2;6 separated by the recesses 3 as before and the latter filled with memory material 11, which also covers the top surfaces of the electrodes 2,6. Now follows the gate electrode 10 which may be separated from the adjacent neighbouring stack by a separation layer 12. This separation layer could be a separate material and for the sake of that consist of a dielectric memory material 11, but could also be a barrier coating with insulating properties applied to the gate electrodes 10. As the gate electrodes 10 in a stacked two-dimensional array S is followed by the layer of semiconducting material 1 in the adjacent neighbouring two-dimensional matrix-addressable array this layer of semiconducting material could be treated to form a barrier layer at its surface adjacent to the gate electrode, e.g. by ensuring that a surface of an inorganic semiconducting material used in layer 1 e.g. is oxidized before it is located upon the underlying stack. This is of course easy to achieve when the inorganic semiconducting material as silicon, by simply performing a surface oxidation thereof.

In principle there will be no limitation as to the number of stacked layers S that can be used to form a three-disnensional matrix-addressable array, but there will of course be certain practical limits imposed, say by mechanical or thermal constraints and the requirement to avoid an increased bumpiness in the stacked structure as the number of stacked layers increases. However, these are well-understood technical problems and can partly be obviated by taking necessary precautions as known to persons skilled in the art.

It will be seen that the present invention provides a matrix-addressable array of integrated transistor/memory structure in two or three dimensions with the integration of memory cells with transistor switches and allowing the switching of either to take place in separate voltage regimes, without a switching of e.g. a memory cell affecting the transistor integrated therewith. Information to be processed or for device operation can be stored in memory cells integrated in the transistor circuitry and hence eliminate the need for external access and peripheral storage devices.

Moreover, it will be obvious that in any two-dimensional array it will be possible to separate groups of transistor/memory structures and form circuit arrangements thereof as desired, e.g. by removing these transistor memory structures in certain portions of the two-dimensional array and then providing appropriate vias and interconnects with necessary insulation and barrier layers as required to form, say logic cells and arithmetic registers with integrated memory in a combined processor/memory circuit which moreover also can be realized in three dimensions allowing a higher degree of connectivity. This opens for completely new perspectives for creating integrated processor/memory structures of high complexity and in dense arrangements allowing high speed and extremely fast memory access with the necessary registers provided internally and without the circuitry being subject to the usual topological constrains inherent in much of present day integrated circuit technology being based on say silicon.

## Claims

1. A matrix-addressable array of integrated transistor/memory structures, wherein the array comprises at least one layer (1) of semiconducting material, at least a first (E₁) and second (E₂) electrode layers including electrodes (2,6,10), as well as a memory material (11) contacting said electrodes (2,6,10), wherein the memory material (11) is a polarizable dielectric material capable of exhibiting hysteresis, particularly a ferroelectric or electret material, wherein the second electrode layer (E₂) is above the first electrode layer (E₁) which is above the layer (1) of semiconducting material, wherein the electrodes (2,6,10) in said first and second electrode layers (E₁;E₂) in each layer are provided as continuous or interrupted parallel extended structures,
wherein said at least one layer (1) of semiconducting material and said first and second electrode layers (E₁;E₂) form field-effect transistor structures, wherein the electrodes (2,6) of the first electrode layer (E₁) form the source/drain electrode pairs of said field-effect transistor structures, wherein the electrodes (10) of the second electrode layer (E₂) forms the gate electrodes (10) of the field-effect transistor structures, the gate electrodes in any case provided in a substantial orthogonal orientation relative to the electrodes (2,6) of the first electrode layer (E₁),
**characterized in that** the source and drain electrodes (2;6) of a single transistor/memory structure (T₁) are separated by a narrow vertical recess (3) extending therebetween and down to the layer (1) of semiconducting material, that a transistor channel (8) is provided in the semiconducting layer (1) beneath the recess (3) between the source and drain electrodes (2;6), that the source and drain regions (9;5) of the transistor structures are provided beneath the source and drain electrodes (2;6) at either side of the transistor channel (8), that the memory material (11) is provided filling the recess (3) between the source and drain electrodes (2;6) and filling a space between the gate electrode (10) and the drain electrode (6) and between the gate electrode (10) and the source electrode (2) such that the memory material (11) contacts the gate (10), the source (2) and the drain (6) electrodes whereby the transistor channel (8) is defined with a length L corresponding to the width of the recess (3) and a width W corresponding to the width of the gate electrode (10), L being a fraction of W, and that three memory cells (11a, 11b, 11c) are defined in the memory material (11) respectively between the source electrode (2) and the gate electrode (10), between the drain electrode (6) and the gate electrode (10) and in the recess between the source and drain electrodes (2;6).

2. A matrix-addressable array according to claim 1,
**characterized in that** a transistor/memory structure (T₁) comprises a third electrode layer (10') of semiconducting material opposite the source and drain electrode layer (E₁), said third electrode layer (10') comprising a second gate electrode extending in the same direction as the first gate electrode (10) and registering therewith, whereby the transistor/memory structure is realized as a dual gate field-effect transistor.

3. A matrix-addressable array according to claim 1,
**characterized in that** the first memory cell (11 a) contacts the source and the gate electrodes (2;10).

4. A matrix-addressable array according to claim 1,
**characterized in that** the second memory cell (11b) contacts the drain and the gate electrodes (6;10).

5. A matrix-addressable array according to claim 1,
**characterized in that** the third memory cell (11c) contacts the source and the drain electrodes (2;6).

6. A matrix-addressable array according to claim 5,
**characterized in that** the memory material (11) in the third memory cell (11c) has a thickness different from that of the first and second memory cells (11a;11b).

7. A matrix-addressable array according to claim 5,
**characterized in that** the memory material (11) is a ferroelectric or electret organic material, preferably a polymer or copolymer.

8. A matrix-addressable array according to claim 1,
**characterized in that** the semiconducting material is an inorganic semiconducting material, preferably amorphous silicon, polycrystalline silicon or microcrystalline silicon.

9. A matrix-addressable array according to claim 1,
**characterized in that** the semiconducting material is an organic semiconducting material, preferably a semiconducting polymer or pentacene.

10. A matrix-addressable array according to claim 1,
**characterized in that** an additional transistor/memory structure (T₂) is provided in registration with the first single transistor/memory structure (T₁) opposite the gate electrode (10) thereof and inverted in relation to the first single transistor memory structure, said additional transistor/memory structure (T2) sharing the same gate electrode (10) with the latter (T1), thus realizing a dual transistor/memory structure with common gate and six memory cells.

11. A matrix-addressable array according to claim 10,
**characterized in that** the dual transistor/memory structure realizes a common gate complementary field-effect transistor.

12. A matrix-addressable array according to claim 10,
**characterized in that** the dual transistor/memory structure is provided with at least one additional gate electrode (10'), said at least one additional gate electrode being provided on one of the layers (1) of semiconducting material opposite the source/drain electrode layer.

13. A matrix-addressable array according to claim 1,
**characterized in that** the matrix-addressable array is realized as a three-dimensional array by stacking two or more two-dimensional arrays (5) of transistor/memory structures, and that a two-dimensional array is isolated from an adjacent neighbouring two-dimensional array by a separation layer (12).

14. A matrix-addressable array according to claim 13,
**characterized in that** the separation layer (12) is selected as one of the following, viz. a layer of insulating material, a layer of conducting or semiconducting material coated to form an insulating barrier, or a layer of conducting or semiconducting material surface-oxidized to form the insulating barrier.

## Patentansprüche

1. Matrix-adressierbares Array von integrierten Transistor-/Speicherstrukturen,
wobei das Array mindestens eine Schicht (1) aus Halbleitermaterial, mindestens eine erste Elektrodenschicht (E1) und eine zweite Elektrodenschicht (E2), die Elektroden (2, 6, 10) besitzen, sowie ein Speichermaterial (11) aufweist, das mit den Elektroden (2, 6, 10) in Kontakt steht,
wobei das Speichermaterial (11) ein polarisierbares dielektrisches Material ist, das Hysterese zeigen kann, insbesondere ein ferroelektrisches Material oder Elektret-Material,
wobei die zweite Elektrodenschicht (E2) sich oberhalb der ersten Elektrodenschicht (E1) befindet, die sich oberhalb der Schicht (1) aus Halbleitermaterial befindet,
wobei die Elektroden (2, 6, 10) in den ersten und zweiten Elektrodenschichten (E1; E2) in jeder Schicht als kontinuierliche oder unterbrochene parallel verlaufende Strukturen vorgesehen sind,
wobei die mindestens eine Schicht (1) aus Halbleitermaterial und die ersten und zweiten Elektrodenschichten (E1; E2) Feldeffekttransistor-Strukturen bilden,
wobei die Elektroden (2, 6) der ersten Elektrodenschicht (E1) Source/Drain-Elektrodenpaare der Feldeffekttransistor-Strukturen bilden,
wobei die Elektroden der zweiten Elektrodenschicht (E2) die Gateelektroden (10) der Feldeffekttransistor-Strukturen bilden, wobei die Gateelektroden in jedem Falle in einer im wesentlichen orthogonalen Orientierung relativ zu den Elektroden (2, 6) der ersten Elektrodenschicht (E1) vorgesehen sind,
**dadurch gekennzeichnet,**
**daß** die Source- und Drainelektroden (2; 6) einer einzelnen Transistor-/Speicherstruktur (T1) mit einer schmalen vertikalen Aussparung (3) getrennt sind, die sich dazwischen und hinunter zu der Schicht (1) aus Halbleitermaterial erstreckt,
**daß** ein Transistorkanal (8) in der Halbleiterschicht (1) unterhalb der Aussparung (3) zwischen den Source- und Drainelektroden (2; 6) vorgesehen ist, daß die Source- und Drainbereiche (9; 5) der Transistorstrukturen unterhalb der Source- und Drainelektroden (2; 6) zu beiden Seiten des Transistorkanals (8) vorgesehen sind,
**daß** das Speichermaterial (11) die Aussparung (3) zwischen den Source- und Drainelektroden (2; 6) ausfüllend vorgesehen ist und einen Raum zwischen der Gateelektrode (10) und der Drainelektrode (6) sowie zwischen der Gateelektrode (10) und der Sourceelektrode (2) ausfüllt, so daß das Speichermaterial (11) mit der Gateelektrode (10), der Sourceelektrode (2) und der Drainelektrode (6) in Kontakt steht,
so daß der Transistorkanal (8) mit einer Länge L, die der Breite der Aussparung (3) entspricht, und einer Breite W ausgebildet ist, die der Breite der Gateelektrode (10) entspricht, wobei L ein Bruchteil von W ist,
und **daß** drei Speicherzellen (11a, 11b, 11c) in dem Speichermaterial (11) jeweils zwischen der Sourceelektrode (2) und der Gateelektrode (10), zwischen der Drainelektrode (6) und der Gateelektrode (10) sowie in der Aussparung zwischen den Source- und Drainelektroden (2; 6) ausgebildet sind.

2. Matrix-adressierbares Array nach Anspruch 1,
**dadurch gekennzeichnet,**
**daß** eine Transistor-/Speicherstruktur (T1) eine dritte Elektrodenschicht (10') aus Halbleitermaterial, der Source- und Drainelektrodenschicht (E1) gegenüberliegend aufweist, wobei die dritte Elektrodenschicht (10') eine zweite Gateelektrode aufweist, die sich in der gleichen Richtung wie die erste Gateelektrode (10) erstreckt und mit dieser zusammenpaßt, so daß die Transistor-/Speicherstruktur als Feldeffekttransistor mit zwei Gates realisiert ist.

3. Matrix-adressierbares Array nach Anspruch 1,
**dadurch gekennzeichnet,**
**daß** die erste Speicherzelle (11a) mit den Source- und Gateelektroden (2; 10) in Kontakt steht.

4. Matrix-adressierbares Array nach Anspruch 1,
**dadurch gekennzeichnet,**
**daß** die zweite Speicherzelle (11b) mit den Drain- und Gateelektroden (6; 10) in Kontakt steht.

5. Matrix-adressierbares Array nach Anspruch 1,
**dadurch gekennzeichnet,**
**daß** die dritte Speicherzelle (11c) mit den Source- und Drainelektroden (2; 6) in Kontakt steht.

6. Matrix-adressierbares Array nach Anspruch 5,
**dadurch gekennzeichnet,**
**daß** das Speichermaterial (11) in der dritten Speicherzelle (11c) eine Dicke besitzt, die sich von der der ersten und zweiten Speicherzellen (11a ; 11b) unterscheidet.

7. Matrix-adressierbares Array nach Anspruch 5,
**dadurch gekennzeichnet,**
**daß** das Speichermaterial (11) ein ferroelektrisches oder organisches Elektret-Material ist, vorzugsweise ein Polymer oder Copolymer.

8. Matrix-adressierbares Array nach Anspruch 1,
**dadurch gekennzeichnet,**
**daß** das Halbleitermaterial ein anorganisches Halbleitermaterial ist, vorzugsweise amorphes Silizium, polykristallines Silizium oder mikrokristallines Silizium.

9. Matrix-adressierbares Array nach Anspruch 1,
**dadurch gekennzeichnet,**
**daß** das Halbleitermaterial ein organisches Halbleitermaterial ist, vorzugsweise ein halbleitendes Polymer oder Pentacen.

10. Matrix-adressierbares Array nach Anspruch 1,
**dadurch gekennzeichnet,**
**daß** eine zusätzliche Transistor-/Speicherstruktur (T2) in Übereinstimmung mit der ersten einzelnen Transistor-/Speicherstruktur (T1) vorgesehen ist, und zwar ihrer Gateelektrode (10) gegenüberliegend und umgekehrt in Relation zu der ersten einzelnen Transistor-/Speicherstruktur, wobei die zusätzliche Transistor-/Speicherstruktur (T2) dieselbe Gateelektrode (10) mit der letzteren Struktur (T1) teilt, so daß eine doppelte Transistor-/Speicherstruktur mit gemeinsamem Gate und sechs Speicherzellen realisiert ist.

11. Matrix-adressierbares Array nach Anspruch 10,
**dadurch gekennzeichnet,**
**daß** die doppelte Transistor-/Speicherstruktur einen komplementären Feldeffekttransistor mit gemeinsamem Gate bildet.

12. Matrix-adressierbares Array nach Anspruch 10,
**dadurch gekennzeichnet,**
**daß** die doppelte Transistor-/Speicherstruktur mit mindestens einer zusätzlichen Gateelektrode (10') versehen ist, wobei die mindestens eine zusätzliche Gateelektrode auf einer der Schichten (1) aus Halbleitermaterial gegenüber der Source/Drain-Elektrodenschicht vorgesehen ist.

13. Matrix-adressierbares Array nach Anspruch 1,
**dadurch gekennzeichnet,**
**daß** das Matrix-adressierbare Array als dreidimensionales Array ausgebildet ist, in dem zwei oder mehr zweidimensionale Arrays (5) aus Transistor-/Speicherstrukturen aufeinandergestapelt sind,
und **daß** ein zweidimensionales Array von einem angrenzenden benachbarten zweidimensionalen Array mit einer Trennschicht (12) getrennt ist.

14. Matrix-adressierbares Array nach Anspruch 13,
**dadurch gekennzeichnet,**
**daß** die Trennschicht (12) als eine aus den folgenden Schichten gewählt ist, nämlich einer Schicht aus Isoliermaterial, einer Schicht aus leitendem oder halbleitendem Material, das zur Bildung einer isolierenden Barriere beschichtet ist, oder einer Schicht aus leitendem oder halbleitendem Material, dessen Oberfläche oxidiert ist, um die isolierende Barriere zu bilden.

## Revendications

1. Réseau à adressage de matrice de structures transistor/mémoire intégrées, dans lequel le réseau comprend au moins une couche (1) de matériau semi-conducteur, au moins une première (E₁) et une deuxième (E₂) couches d'électrode comprenant des électrodes (2, 6, 10), ainsi qu'un matériau de mémoire (11) en contact avec lesdites électrodes (2, 6, 10), dans lequel le matériau de mémoire (11) est un matériau diélectrique polarisable capable de présenter une hystérésis, en particulier un matériau ferroélectrique ou électret, dans lequel la deuxième couche d'électrode (E₂) est au-dessus de la première couche d'électrode (E1) qui est au-dessus de la couche (1) de matériau semi-conducteur, dans lequel les électrodes (2, 6 10) dans lesdites première et deuxième couches d'électrode (E₁ ; E₂) dans chaque couche sont disposées comme des structures étendues parallèles continues ou interrompues, dans lequel ladite au moins une couche (1) de matériau semi-conducteur et lesdites première et deuxième couches d'électrode (E₁ ; E₂) forment des structures de transistor à effet de champ, où les électrodes (2, 6) de la première couche d'électrode (E₁) forment la paire d'électrodes source/drain desdites structures de transistor à effet de champ, où les électrodes (10) de la deuxième couche d'électrode (E₂) forme l'électrode de grille (10) desdites structures de transistor à effet de champ, les électrodes de grille étant disposées dans tous les cas dans une orientation sensiblement orthogonale par rapport forment aux électrodes (2, 6) de la première couche d'électrode (E₁),
**caractérisé en ce que** les électrodes de source et de drain (2 ; 6) d'une structure de transistor/mémoire (T₁) individuelle sont séparées par une cavité verticale étroite (3) s'étendant entre elles et vers le bas vers la couche (1) de matériau semi-conducteur, **en ce qu'**un canal de transistor (8) est disposé dans la couche de semi-conducteur (1) au-dessous de la cavité (3) entre les électrodes de source et de drain (2 ; 6), **en ce que** les régions de source et de drain (9 ; 5) des structures de transistor sont disposées au-dessous des électrodes de source et de drain (2 ; 6) d'un côté ou de l'autre du canal de transistor (8), **en ce que** le matériau de mémoire (11) est disposé en remplissant la cavité (3) entre les électrodes de source et de drain (2 ; 6) et en remplissant un espace entre l'électrode de grille (10) et l'électrode de drain (6) et entre l'électrode de grille (10) et l'électrode de source (2) de manière que le matériau de mémoire (11) soit en contact avec les électrodes de grille (10), de source (2) et de drain (6) moyennant quoi le canal de transistor (8) est défini avec une longueur L correspondant à la largeur de la cavité (3) et une largeur W correspondant à la largeur de l'électrode de grille (10), L étant une fraction de W, et **en ce que** trois cellules de mémoire (11a, 11b, 11c) sont définies dans le matériau de mémoire (11) respectivement entre l'électrode de source (2) et l'électrode de grille (10), entre l'électrode de drain (6) et l'électrode de grille (10) et dans la cavité entres les électrodes de source et de drain (2 ; 6).

2. Réseau à adressage de matrice selon la revendication 1, **caractérisé en ce qu'**une structure de transistor/mémoire (T₁) comprend une troisième couche d'électrode (10') de matériau semi-conducteur opposée à la couche d'électrode de source et de drain (E₁), ladite troisième couche d'électrode (10') comprenant une deuxième électrode de grille s'étendant dans la même direction que la première électrode de grille (10) et s'alignant avec celle-ci, moyennant quoi la structure de transistor/mémoire est réalisée comme un double transistor à effet de champ.

3. Réseau à adressage de matrice selon la revendication 1, **caractérisé en ce que** la première cellule de mémoire (11a) est en contact avec les électrodes de source et de grille (2 ; 10).

4. Réseau à adressage de matrice selon la revendication 1, **caractérisé en ce que** la deuxième cellule de mémoire (11b) est en contact avec les électrodes de drain et de grille (6 ; 10).

5. Réseau à adressage de matrice selon la revendication 1, **caractérisé en ce que** la troisième cellule de mémoire (11c) est en contact avec les électrodes de source et de drain (2 ; 6).

6. Réseau à adressage de matrice selon la revendication 5, **caractérisé en ce que** le matériau de mémoire (11) dans la troisième cellule de mémoire (11c) a une épaisseur différente de celle des première et deuxième cellules de mémoire (11a ; 11b).

7. Réseau à adressage de matrice selon la revendication 5, **caractérisé en ce que** le matériau de mémoire (11) est un matériau organique ferroélectrique ou électret, de préférence un polymère ou copolymère.

8. Réseau à adressage de matrice selon la revendication 1, **caractérisé en ce que** le matériau semi-conducteur est un matériau semi-conducteur inorganique, de préférence du silicium amorphe, silicium poly-cristallin ou silicium microcristallin.

9. Réseau à adressage de matrice selon la revendication 1, **caractérisé en ce que** le matériau semi-conducteur est un matériau semi-conducteur organique, de préférence un polymère ou pentacène semi-conducteur.

10. Réseau à adressage de matrice selon la revendication 1, **caractérisé en ce qu'**une structure de transistor/mémoire additionnelle (T₂) est disposée en alignement avec la première structure de transistor/mémoire individuelle. (T₁) opposée à l'électrode de grille (10) de celle-ci et inversée par rapport à la première structure de transistor/mémoire individuelle, ladite structure de transistor/mémoire additionnelle (T₂) partageant la même électrode de grille (10) avec cette dernière (T₁), en réalisant ainsi une double structure de transistor/mémoire avec grille commune et six cellules de mémoire.

11. Réseau à adressage de matrice selon la revendication 10, **caractérisé en ce que** la double structure de transistor/mémoire réalise un transistor à effet de champ complémentaire à grille commune.

12. Réseau à adressage de matrice selon la revendication 10, **caractérisé en ce que** la double structure de transistor/mémoire est munie d'au moins une électrode de grille additionnelle (10'), ladite au moins une électrode de grille additionnelle étant disposée sur une des couches (1) de matériau semi-conducteur opposée à la couche d'électrode de source/drain.

13. Réseau à adressage de matrice selon la revendication 1, **caractérisé en ce que** le réseau à adressage de matrice est réalisé comme un réseau tridimensionnel en empilant deux ou plus de deux réseaux bidimensionnels (5) de structures de transistor/mémoire et **en ce qu'**un réseau bidimensionnel est isolé d'un réseau bidimensionnel voisin adjacent par une couche de séparation (12).

14. Réseau à adressage de matrice selon la revendication 13, **caractérisé en ce que** la couche de séparation (12) est sélectionnée comme l'une des suivantes, c'est-à-dire une couche de matériau isolant, une couche de matériau conducteur ou semi-conducteur enduite pour former une barrière isolante, ou une couche de matériau conducteur ou semi-conducteur oxydée en surface pour former la barrière isolante.
